Europäisches Patentamt

European Patent Office

Office européen des brevets

(19)

(11) Veröffentlichungsnummer: **0 013 317**
**B1**

(12) **EUROPÄISCHE PATENTSCHRIFT**

(45) Veröffentlichungstag der Patentschrift: 04.07.84

(21) Anmeldenummer: 79104584.2

(22) Anmeldetag: 19.11.79

(51) Int. Cl.³: **H 01 L 21/28, H 01 L 21/00**

(54) Verfahren zur Herstellung von Feldeffekttransistoren.

(30) Priorität: 29.12.78 US 974577

(43) Veröffentlichungstag der Anmeldung:
23.07.80 Patentblatt 80/15

(45) Bekanntmachung des Hinweises auf die Patenterteilung:
04.07.84 Patentblatt 84/27

(84) Benannte Vertragsstaaten:
DE FR GB

(56) Entgegenhaltungen:
SOLID-STATE ELECTRONICS, Band 21, Heft 9,
September 1978, OXFORD (GB) B.A. BOXALL:
"A Technique for Producing Polysilicon Patterns
with Bevelled Edge Profiles using wet etching",
Seiten 1173-1174

PATENT ABSTRACTS OF JAPAN, Band 2, Heft
92, 28. Juli 1978, TOKYO (JP)

CHEMICAL ABSTRACTS, Band 83, Heft 24, 15.
Dezember 1975, Seite 521, Zusammenfassung
200763b, COLUMBUS, OHIO (US) M. KUISL et
al.: "Preparation and properties of phosphorusdoped polycrystalline silicon films"

(73) Patentinhaber: International Business Machines
Corporation
*Old Orchard Road*
**Armonk, N.Y. 10504 (US)**

(72) Erfinder: **Gardiner, James Robert**
**32 Meadow Drive**
**Wappingers Falls New York 12590 (US)**
Erfinder: **Pliskin, William Aaron**
**31 Greenvale Farms Road**
**Poughkeepsie, New York 12603 (US)**
Erfinder: **Revitz, Martin**
**73 Mandalay Drive**
**Poughkeepsie, New York 12603 (US)**
Erfinder: **Shepard, Joseph Francis**
**Country Club Road**
**Hopewell Junction New York 12533 (US)**

(74) Vertreter: **Neuland, Johannes, Dipl.-Ing.**
**Schönaicher Strasse 220**
**D-7030 Böblingen (DE)**

(56) Entgegenhaltungen:
JOURNAL OF THE ELECTROCHEMICAL
SOCIETY, Band 126, Heft 8, 08/1979,
PRINCETON (US) H. YAMANAKA et al.:
"Polysilicon Interconnection Technology for IC
Device", Seiten 1415-1418

## Beschreibung

Die Erfindung bezieht sich auf ein Verfahren zur Herstellung von Feldeffekttransistoren, bei dem auf einem ebenen Halbleiterkörper eine dünne Isolierschicht aufgebracht wird.

Bei der Herstellung von Feldeffekttransistoren, die eine dünne Gate-Oxidschicht und eine Gate-Elektrode aus polykristallinem Silicium aufweisen, auf der ein metallischer Anschlußkontakt durch vertikales Ausrichten mit dem dünnen Gate-Oxid hergestellt wird, war die Ausbeute an guten Bauelementen bisher unerklärlich niedrig. Der Ausfallmechanismus, der für diese geringe Ausbeute verantwortlich ist, scheint der folgende zu sein: Das Dotieren der polykristallinen Siliciumschicht trägt zu übermäßigem Kornwachstum und daraus resultierender Poren-bildung in der aus polykristallinem Silicium bestehenden Gate-Elektrode bei. Während der nachfolgenden Verarbeitung sickert Flußsäure durch die Poren und greift die dünne aus Siliciumdioxid bestehende Isolierschicht an. Daher wurde deren Isolierwirkung wesentlich verringert, so daß Kurzschlüsse und Durchschläge der Bauelemente bei niedrigeren angelegten Spannungen möglich wurden.

Aus Patent Abstracts of Japan, Bd. 2, Heft 92, 28. Juli 1978, Kokai Nr. 52—55 986 ist es bekannt, zur Vermeidung niedriger Durchbruchspannungen beider Herstellung von Feldeffekt transistoren auf eine dünne Isolierschicht eine dotierte polykristalline Siliciumschicht und darüber eine undotierte polykristalline Siliciumschicht aufzubringen und die erhaltene Struktur zu erhitzen.

Hier will die Erfindung Abhilfe schaffen. Die Erfindung, wie sie in den Ansprüchen gekennzeichnet ist, löst die Aufgabe, ein Verfahren zur Herstellung von Feldeffekttransistoren anzugeben, das eine relativ hohe Ausbeute ermöglicht durch Verringerung der Porenbildung in der polykristallinen Schicht und des nachfolgenden Säureangriffs auf das Gate-Oxid, die bisher bei den bekannten Verfahren zur Herstellung von Halbleiterbauelementen mit dünnen Gate-Oxidstrukturen weit verbreitet sind.

Im folgenden wird die Erfindung anhand von lediglich einen Ausführungsweg darstellenden Zeichnungen näher erläutert Von ihnen zeigen:

Fign. 1 bis 4 die üblichen Anfangsschritte eines der Erläuterung dienenden Verfahrens nach der Erfindung: die in diesen Figuren dargestellten Schritte werden vor denjenigen ausgeführt, die die neuen Verfahrensschritte nach der Erfindung bilden und unten beschrieben werden;

Fign. 5 und 6 die neuen Schritte des Abscheidens einer ersten eigenleitenden Schicht von polykristallinem Silicium und das darauf folgende Abscheiden weiterer Schichten von dotiertem polykristallinem Silicium;

Fign. 7 bis 13 die nachfolgenden üblichen Schritte, die nach den in den Figuren 5 und 6 dargestellten neuen Verfahrensschritten ausgeführt werden.

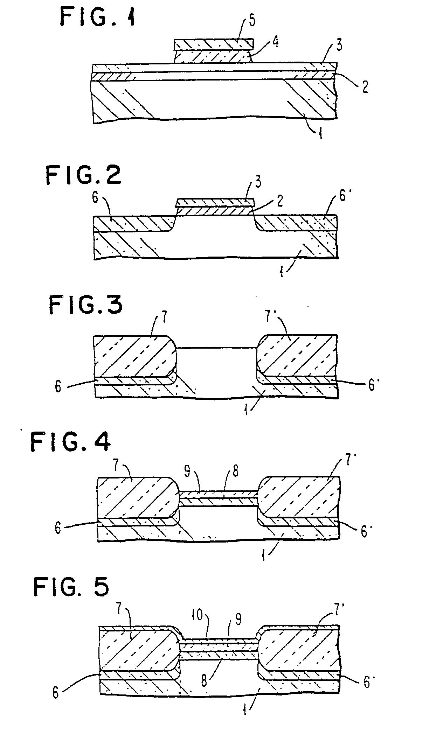

In Fig. 1 bezeichnet die Bezugszahl 1 eine Halbleiterscheibe oder ein Substrat, das vorzugsweise p-leitend ist. Auf der oberen Fläche des Substrates 1 ist eine Siliciumdioxidschicht 2 mit einer Dicke von etwa 30 nm (300 Å) aufgewachsen. Auf der Schicht 2 ist eine Siliciumnitridschicht 3 mit einer Dicke von etwa 30 nm (300 Å) aufgebracht. Eine zweite Silciumdioxidschicht 4 mit einer Dicke von etwa 50 nm (500 Å) ist auf der Schicht 3 abgeschieden. Eine Photolackschicht 5 ist auf der Siliciumdioxidschicht 4 aufgebracht. Während die Schichten 2, 3 und 4 sich über die obere Fläche des Substrates 1 erstrecken, ist die Photolackschicht 5 in der dargestellten Weise geformt. Das Substrat wird dann einem üblichen Ätzverfahren unterworfen, um diejenigen Teile der Siliciumdioxidschicht 4 wegzuätzen, die nicht durch die Photolackschicht 5 geschützt sind. Die erhaltende Struktur ist in Fig. 1 dargestellt.

Das Substrat wird dann wie in Fig. 2 dargestellt ist, einer Implantation von Bor-Ionen unterworfen, um die Source- und Drainbereiche 6, 6' zu erzeugen, die mit Bor dotiert sind. Die Bor-Ionen durchdringen die Siliciumdioxidschicht 2 und die Siliciumnitridschicht 3, aber sie durchdringen nicht die Photolackschicht 5, die als Maske dient, um die Implantation auf die gewünschten Bereiche 6, 6' zu begrenzen. Die Photolackschicht 5 wird dann abgezogen. Die Siliciumdioxid schicht 2 und die Siliciumnitridschicht 3 werden dann weggeätzt mit Ausnahme derjenigen Teile direkt unter der Siliciumdioxidschicht 4, die als Maske dient. Die letztere selbst wird gegebenenfalls während dieses Ätzschrittes entfernt, wodurch die in Fig. 2 dargestellte Struktur erzeugt wird.

Die Siliciumnitridschicht 3 dient als Maske für den nächsten, in Fig. 3 dargestellten Schritt des Aufwachsens einer dicken Siliciumdioxidschicht von über 500 nm (5000 Å), um die mit 7, 7' bezeichneten Oxidbereiche zu erzeugen. Die Siliciumnitridschicht 3 und die Siliciumdioxidschicht 2 nach Fig. 2 werden dann entfernt, um die in Fig. 3 dargestellt Struktur zu erzeugen. Die Oxidbereiche 7, 7' wachsen nach unten in die oberen Teile der mit Bor implantierten Bereiche 6, 6'.

Nach Fig. 4 ist eine dünne Siliciumdioxidschicht 9 auf den Bereich aufgewachsen, der durch die Öffnungen zwischen den Bereichen 7, 7' des dicken Oxids freigelegt ist. Die Siliciumdioxidschicht 9 stellt die isolierende Gate-Oxidschicht für das Bauelement dar, das gebildet wird. Die Silciumdioxidschicht 9 weist vorzugsweise eine Dicke von 25 nm (250 Å) auf. Anschließend erfolgt eine Implantation von Bor-Ionen zur Einstellung der Schwellenspannung, um den Bor dotierten Bereich 8 unmittelbar unter der Siliciumdioxidschicht 9 zu erzeugen. Die erhaltene Struktur ist in Fig. 4 dargestellt.

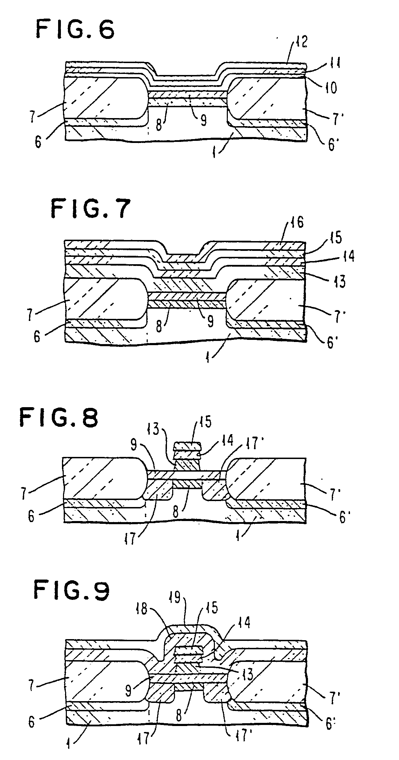

In Verbindung mit den Fign. 5 und 6 werden jetzt die neuen Schritte nach der Erfindung beschrieben. Eine im wesent-lichen eigenleitende Schicht 10 von polykristallinem Silicium wird in einer Stärke von etwa 100 nm (1000 Å) auf das Substrat aufgebracht, um die Gate-Oxidschicht 9 und die Bereiche 7, 7' der dicken Oxidschicht zu bedecken. Die Eigenschaft der Eigenleitung der polykristallinen Siliciumschicht 10 ist entscheidend für die Erfindung, wie unten erklärt wird. Die erhaltene Struktur ist die in Fig. 5 dargestellte.

Nach Fig. 6 wird eine zweite polykristalline Siliciumschicht 11 in einer Dicke von etwa 100 nm (1000 Å) auf die zuerst abgeschiedene eigenleitende Schicht 10 aufgebracht. Die zweite polykristalline Schicht 11 ist mäßig dotiert, vorzugsweise mit einer Konzentration von etwa $10^{18}$ Phosphor-Störstellenatomen/cm³. Eine dritte polykristalline Siliciumschicht 12 wird in einer Dicke von etwa 100 nm (1000 Å) auf die zweite Schicht 11 aufgebracht. Diese dritte Schicht 12 ist vorzugsweise stärker dotiert als die Schicht 11. Ihre Störstellenkonzentration beträgt vorzugsweise etwa $10^{20}$ Phosphoratome/cm³. Die resultierende Struktur ist in Fig. 6 dargestellt.

Ein alternatives Verfahren zum Abscheiden der drei Schichten 10, 11, 12 könnte darin bestehen, eine polykristalline Siliciumschicht abzuscheiden, die eine abgestufte Dotierungskonzentration besitzt, wobei man beginnt mit dem im wesentlichen eigenleitendem Material in unmittelbarer Nachbarschaft der dünnen Gate-Oxidschicht 9 und die Dotierungskonzentration in der Richtung weg von der Gate-Oxidschicht 9 stufenweise erhöht.

Eine Folge der nachfolgenden Heißprozeßschritte ist die Diffusion der Dotierungsstoffe der Schichten 11 und 12 in die anfänglich eigenleitende Schicht 10, was zu einem polykristallinen Siliciumgate führt, das das für eine richtige Arbeitsweise erforderliche Profil der Störstellenkonzentration besitzt. Die drei polykristallinen Siliciumschichten 10, 11, 12 sind in Fig. 7 als eine Schicht 13 dargestellt, obgleich daraus nicht gefolgert werden soll, daß die Diffusion des Dotierungsstoffes aus den Schichten 12 und 11 in die Schicht 10 in dieser Stufe des Verfahrens beendet ist.

Der im wesentlichen eigenleitende Charakter der anfänglich abgeschiedenen polykristallinen Schicht 10 sorgt für die wichtigen Vorteile der Erfindung. D. h., das fast vollständige Fehlen eines Dotierungsstoffes verringert das Kornwachstum und die Porenbildung in dem polykristallinen Silicium. Dies wiederum verringert die Neigung der Flußsäure durch die Poren in der polykristallinen Siliciumschicht zu sickern und die dünne Gate-Oxidschicht 9 während der nachfolgenden Prozeßschritte anzugreifen. Die isolierende Funktion der Gate-Oxidschicht 9 bleibt dadurch im wesentlichen erhalten und die Bauelemente weisen höhere Durchbruchsspannungen und weniger Kurzschlüsse auf als es der Fall wäre, wenn die anfänglich abgeschiedene polykristalline Siliciumschicht 10 nicht im wesentlichen eigenleitend wäre.

Es wurde gefunden, daß das Kornwachstum und die Bildung von Poren in der aus polykristallinem Silicium bestehenden Gate-Elektrode noch weiter verringert werden, wenn man dafür sorgt, daß die zweite Schicht 11 nur eine verhältnismäßig niedrige Störstellenkonzentration aufweist und die dritte Schicht 12 eine verhältnismäßig starke.

Die restlichen in den Fign. 7 bis 13 dargestellten Verfahrensschritte sind übliche und werden daher nur summarisch beschrieben. Nach Fig. 7 wird Siliciumdioxidschicht 14 auf die als eine Schicht 13 dargestellten und früher mit 10, 11 und 12 bezeichneten polykristallinen Siliciumschichten aufgewachsen oder auf ihr abgeschieden. Eine Siliciumnitridschicht 15 wird dann auf der Siliciumdioxidschicht 14 abgeschieden und eine weitere Siliciumdioxidschicht 16 auf der Schicht 15. Die Schicht 14 ist vorzugsweise etwa 10 nm (100 Å) dick, die Schicht 15 vorzugsweise etwa 30 nm (300 Å) dick und die Schicht 16 vorzugsweise etwa 50 nm (500 Å) dick. Die erhaltene Struktur ist die in Fig. 7 dargestellte.

Nach Fig. 8 werden übliche photolithographische und Ätzschritte durchgeführt, um die für die Schichten 13, 14 und 15 dargestellten Konfigurationen zu definieren. Danach wird eine Implantation von Arsen-Ionen vorgesehen, um die N+-Bereiche 17, 17' für die Source und Drain zu bilden. Die erhaltene Struktur ist die in Fig. 8 dargestellte.

Nach Fig. 9 wird eine andere polykristalline Siliciumschicht 18 auf dem Substrat abgeschieden, vorzugsweise in einer Dicke von 400 nm (4000 Å) Die Schicht 18 kann dotiert sein, ohne daß die Gefahr besteht, daß das Oxid durch die Flußsäure angegriffen wird, weil die Schicht 18 sich nicht über einen Bereich eines dünnen Oxids erstreckt. Eine Siliciumdioxidschicht 19 wird dann über die Schicht 18 abgeschieden, um die in Fig. 9 dargestellte Struktur zu erhalten.

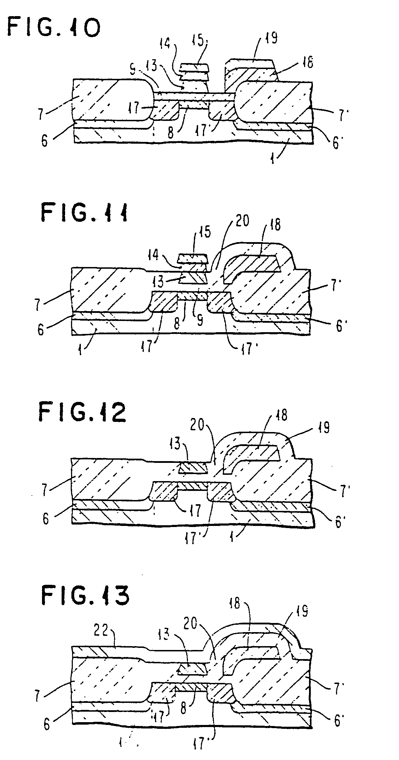

Nach Fig. 10 werden übliche photolithographische und Ätzschritte durchgeführt, um Teile der polykristallinen Siliciumschicht 18 und der Siliciumdioxidschicht 19 zu entfernen. Wie in Fig. 11 dargestellt, wird dann eine dicke Siliciumdioxidschicht von etwa 300 nm (3000 Å) aufgewachsen, die sich mit der Siliciumdioxidschicht 19 und den Bereichen 7, 7' vereinigt, was durch die Bezugsziffer 20 angedeutet wird.

Nach Fig. 12 werden die Siliciumdioxidschicht 14 und die Siliciumnitridschicht 15 anschließend durch einen üblichen Ätzschritt mit Flußsäure entfernt. Während dieses Verfahrensschrittes versucht die Flußsäure, wenn die polykristalline Siliciumschicht 13 für das Gate ein übermäßiges Kornwachstum und eine übermäßige Porenbildung erfahren hatte, durch die Poren zu sickern und die dünne Gate-Oxidschicht 9 anzugreifen, was die Ursache dafür ist, daß das Bauelement eine niedrigere Durchbruchsspannung aufweist. Dadurch, daß man dafür sorgt, daß die anfänglich abgeschiedene polykristalline Siliciumschicht 10 im wesentlichen eigenleitend ist, werden jedoch die Tendenzen zum Kornwachstum und zur Porenbildung während der nachfolgenden Verfahrensschritte wesentlich verringert, wodurch auch die Wahrscheinlichkeit dafür verringert wird, daß die dünne Gate-Oxidschicht 9 durch die Flußsäure angegriffen wird. Diese Wahrscheinlichkeit wird weiter verringert durch die verhältnismäßig niedrige Dotierungskonzentration der zweiten polykristallinen Siliciumschicht 11.

Nach Fig. 13 wird eine Aluminium-Metallisierungsschicht 22 auf dem Substrat und in leitendem Kontakt mit der das Gate 13 bildenden polykristallinen Siliciumschicht abgeschieden, um das Verfahren zu beenden.

## Patentansprüche

1. Verfahren zur Herstellung von Feldeffekttransistoren, bei dem auf einem ebenen Halbleiterkörper eine dünne Isolierschicht (9) aufgebracht wird, gekennzeichnet durch folgende Verfahrensschritte:

a) Aufbringen einer ersten eigenleitenden polykristallinen Halbleiterschicht (10; Fig. 6) auf die dünne Isolierschicht (9),

b) Aufbringen mindestens einer weiteren polykristallinen und dotierten Halbleiterschicht (11) auf die erste eigenleitende polykristalline Halbleiterschicht (10),

c) Erhitzen der erhaltenen Struktur zum Diffundieren eines Teiles des Dotierungsmaterials der weiteren polykristallinen Halbleiterschicht (11) in und durch die erste eigenleitende polykristalline Halbleiterschicht (10) bis zur dünnen Isolierschicht (9) und

d) Aufbringen eines Metallkontaktes (22) auf die als Gate-Elektrode dienenden polykristallinen Halbleiterschichten (13) im Bereich der dünnen Isolierschicht (9).

2. Vefahren nach Anspruch 1, dadurch gekennzeichnet, daß als dünne Isolierschicht (9) eine Oxidschicht verwendet wird.

3. Verfahren nach den Ansprüchen 1 und 2, dadurch gekennzeichnet, daß als Halbleitermaterial Silicium verwendet wird.

4. Verfahren nach den Ansprüchen 1 und 2, dadurch gekennzeichnet, daß als dünne Isolierschicht (9) eine Siliciumdioxidschicht verwendet wird.

5. Verfahren nach den Ansprüchen 1 bis 4, dadurch gekennzeichnet, daß vor Schritt c) auf die weitere polykristalline Siliciumschicht (11) eine dritte polykristalline Siliciumschicht (12) aufgebracht wird, die eine höhere Dotierungskonzentration aufweist als die unter ihr befindliche weitere dotierte polykristalline Siliciumschicht.

## Claims

1. Method of making field effect transistors, where on a planar semiconductor body a thin insulating layer (9) is applied, characterized by the following process steps:

a) applying a first intrinsically conductive polycrystalline semiconductor layer (10; Fig. 6) on the thin insulating layer (9),

b) applying at least one further polycrystalline and doped semiconductor layer (11) on the first intrinsically conductive polycrystalline semiconductor layer (10),

c) heating the thus obtained structure to diffuse part of the doping material of the further polycrystalline semiconductor layer (11) in and through the first intrinsically conductive polycrystalline semiconductor layer (10) down to the thin insulating layer (9), and

d) applying a metal contact (22) on the polycrystalline semiconductor layers (13) serving as gate electrode, in the area of the thin insulating layer (9).

2. Method as claimed in claim 1, characterized in that as thin insulating layer (9) an oxide layer is used.

3. Method as claimed in any one of claims 1 and 2, characterized in that as semiconductor material silicon is used.

4. Method as claimed in any one of claims 1 and 2, characterized in that as insulating layer (9) a silicon dioxide layer is used.

5. Method as claimed in any one of claims 1 to 4, characterized in that prior to step c) onto the further polycrystalline silicon layer (11) a third polycrystalline silicon layer (12) is applied which is of a higher doping concentration than the further doped polycrystalline silicon layer therebeneath.

## Revendications

1. Procédé pour fabriquer des transistors à effet de champ où on dépose une couche d'isolation (9) mince sur un mátériau semiconducteur plan, caractérisé par les étapes suivantes:

a) dépôt d'une première couche semiconductrice polycristalline intrinsèque mince (10; fig. 6) sur ladite couche d'isolation mince (9),

b) dépôt d'au moins une autre couche semiconductrice polycristalline dopée (11) sur la première couche semiconductrice polycristalline intrinsèque mince (10),

c) échauffement de la structure ainsi obtenue afin de diffuser une partie du matériau de dopage contenu dans ladite autre couche semiconductrice polycristalline (11) dans et à travers ladite première couche semiconductrice polycristalline intrinsèque mince (10) jusqu'à la couche d'isolation mince, et

d) dépôt dans la région de ladite couche d'isolation mince (9) d'un contact métallique (22) sur les couches semiconductrices polycristallines (13) servant d'électrode de porte.

2. Procédé selon la revendication 1, caractérisé en ce qu'on utilise une couche d'oxyde comme couche d'isolation mince (9).

3. Procédé selon les revendications 1 et 2, caractérisé en ce qu'on utilise du silicium comme matériau semiconducteur.

4. Procédé selon les revendications 1 et 2, caractérisé en ce qu'on utilise une couche de dioxyde de silicium comme couche d'isolation mince (9).

5. Procédé selon les revendications 1 à 4, caractérisé en ce qu'avant d'éxécuter l'étape c), on dépose sur ladite autre couche polycristalline (11) une troisième couche polycristalline de silicium (12) dont la concentration de dopage est plus élevée que celle de ladite autre couche polycristalline dopée de silicium sous-jacente.

FIG. 1

FIG. 2

FIG. 3

FIG. 4

FIG. 5

**FIG. 6**

**FIG. 7**

**FIG. 8**

**FIG. 9**

2

## FIG. 10

## FIG. 11

## FIG. 12

## FIG. 13

3